# EUROPEAN PATENT APPLICATION

(11) **EP 2 116 635 A2**
(43) Date of publication of application: **11.11.2009**
(21) Application number: 09157926.8
(22) Date of filing: 15.04.2009
(51) Int. Cl.: C30B 7/08, C30B 29/30, H01M 4/02

(54) **production method of layered crystal material**

(30) Priority: 24.04.2008 JP 2008113614
(71) Applicant: Fuji Jukogyo Kabushiki Kaisha, Tokyo 160-0023 (JP)
(72) Inventor: Shiozaki, Ryuji, Tokyo 160-8316 (JP); Maruyama, Daisuke, Tokyo 160-8316 (JP); Ando, Nobuo, Tokyo 160-8316 (JP)
(74) Representative: Sajda, Wolf E.

(57) **Abstract**

An ammonium metavanadate is heat-treated to 500 °C or less at a predetermined rate of temperature rise, whereby microcrystal particles of a vanadium pentoxide can be formed. According to the production method described above, crystals of a nano-vanadium having a layer length of 100 nm or less can be formed. The nano-vanadium formed by the production method described above can effectively be used for an electrode (11, 12) of an electric storage device (10) such as a battery. The production method according to the present invention can be linked to a conventional production method in which an ammonium metavanadate can be formed in the course of the method, whereby the present invention can smoothly be embodied.

## Description

### BACKGROUND OF THE INVENTION

### 1. Field of the Invention

The present invention relates to a technique of a layered crystal material of a vanadium oxide, and more particularly to a technique well adaptable to a positive electrode active material or the like of a lithium ion secondary battery.

### 2. Description of the Related Arts

The technique described below has been studied for completing the present invention. The summary is as follows.

In a lithium ion secondary battery, a battery performance is enhanced by using, for a positive electrode, an active material having lithium ions intercalated therein at the beginning. A vanadium pentoxide is a promising material as the active material. It has been found that a vanadium pentoxide having a crystal structure with a predetermined layer length is effective for the positive electrode active material, as disclosed in Japanese Patent Application No. 2006-306018.

As disclosed in the aforesaid application, the vanadium pentoxide described above is manufactured through a production method described below. Specifically, a vanadium pentoxide is used for a vanadium source as a layered crystal material. Lithium sulfide is used as a lithium source. 3,4-ethylenedioxythiophene (EDOT) is used as a sulfur-containing organic conductive material.

The three materials described above are suspended in water, and heated to reflux. Thereafter, the resultant is filtered, and then the filtrate is concentrated. After the concentration, the resultant is dried under vacuum, and pulverized by a ball mill. After the pulverization, the resultant is classified, whereby powders of layered crystal material are obtained. The obtained powders can effectively be used as the active material for the positive electrode.

The layered microcrystal particles of a vanadium pentoxide obtained by the production method described above cannot be obtained alone, but an amorphous state is mixedly present. Specifically, in the production method described in the above-mentioned application, the progress of amorphization is adjusted by paying attention to the temperature for the heating, temperature for the concentration, or the like, whereby the microcrystal particle having a predetermined layer length is obtained.

The application described above reports that the microcrystal particle of a vanadium pentoxide can greatly enhance battery performance. However, the material manufactured by the production method proposed so far has both the amorphous state and the microcrystal particles mixedly present. Even when the material described above is used as a positive electrode active material, the degree of effect on the performace cannot correctly be estimated because the mixture state is delicately changed. Specifically, the ratio of the microcrystal particles and the amorphous state cannot correctly be determined.

The charging/discharging characteristic is deteriorated at the amorphous state. Thus, the presence of the amorphous state is non-preferable. When the amorphous state is mixedly present, there arises a problem that an electrolyte solution is difficult to be permeated into the surrounding of the microcrystal particles. In this case, the contact efficiency between the microcrystal particles and the electrolyte solution is lowered, with the result that a high cycle characteristic might not be achieved.

In view of this, the present inventors have thought of the possibility of decreasing the amorphous state as much as possible, or eliminating the amorphous state completely. If the amorphous state is decreased as much as possible, or the amorphous state can completely be eliminated, the estimation of the characteristic based on the obtained active material can be determined to be the one achieved by the material from which the amorphous state is eliminated. There must be the case in which the affect by the amorphous state is negligible. Specifically, the characteristic can be considered to be the one based on the layered crystal material composed of the microcrystal particles of vanadium pentoxide.

The present inventors have made various studies so far about the production method of microcrystal particles of a vanadium pentoxide having a layer length of less than 100 nm. In the production method of microcrystal particles that has been studied so far, a vanadium pentoxide has been used as a material. Specifically, in order to acquire microcrystals of a vanadium pentoxide, a vanadium pentoxide has been used as a material.

The microcrystals of a vanadium oxide such as a vanadium pentoxide having a layer length of 100 nm or less is referred to as a micro-poly crystalline vanadium below. In the present specification, it is sometimes briefly referred to as a nano-vanadium.

This method can be understood if it is carried out in a laboratory scale, but this method is obviously unfavorable when it is considered in a production scale as a real industrial process. Specifically, in the production method that has been studied so far by the present inventors, the vanadium pentoxide whose crystal structure is larger than the nano-vanadium has been used as a material. After the vanadium pentoxide has been dissolved, it is re-crystallized, whereby the vanadium pentoxide (nano-vanadium) having a microcrystal structure smaller than the crystal structure of the material is obtained. However, the present inventors have found out that this method needs duplication of work.

In other words, the vanadium pentoxide used as the material has to be produced through a crystallization process. The crystals are dissolved, and subjected again to the crystallization process to form microcrystals. So to speak, the vanadium pentoxide is subjected to the crystallization process twice. Of course, the respective crystallization processes are different. However, they are considered to be the same from the viewpoint of crystallizing the vanadium pentoxide.

It is currently convenient to use a crystal of a commercially available vanadium pentoxide for the production method of microcrystal particles of a vanadium pentoxide, which is a nano-vanadium. However, the commercially available vanadium pentoxide is not present as microcrystals of nano-vanadium having a layer length of 100 nm or less. The layer length of the crystal structure is greater than 100 nm. The present inventors have considered that the double crystallization process becomes a major bottleneck, when the demand of the microcrystal particles of the vanadium pentoxide has been increased in the future.

The layer length of the layered crystal structure of the crystal material of the vanadium pentoxide, which can currently be available, and the layer length of the layered crystal structure of the microcrystals of the vanadium pentoxide, which is the nano-vanadium that is the final form, are different from each other. If so, the crystal material of the vanadium pentoxide, which is currently available, should not be a large crystal at the beginning. The present inventors have considered that, from the beginning, the crystal material should be made into microcrystals having a size of a target nano-vanadium. In view of this, the present inventors have considered whether the microcrystal structure having a layer length of 100 nm or less can directly be produced, for example.

If the microcrystal structure can directly be produced, the time and effort needed to obtain microcrystal particles of a vanadium pentoxide by the re-crystallization with the use of the crystals of the vanadium pentoxide, which is a material so far, can completely be eliminated. Specifically, the number of processes can remarkably be decreased when compared with the method studied so far by the present inventors in the production of the microcrystal particles of the vanadium pentoxide. Further, the production cost can be lowered.

The present inventors have also considered that it is preferable if the method of making the vanadium pentoxide into microcrystals, which is the nano-vanadium, can be linked to the production method of the material of the vanadium pentoxide having a layer length longer than the nano-vanadium. Specifically, if the method can be linked to the conventional production method, at least some facilities and apparatuses in the conventional method can be used as unchanged. If so, the present inventors have conceived that the conventional production method can very smoothly and promptly be changed to the production method according to the present invention.

### SUMMARY OF THE INVENTION

The present invention aims to efficiently produce microcrystals of a vanadium pentoxide having a layer length of 100 nm or less.

The foregoing and other objects and novel features of the present invention will be apparent from the description of the specification of the present application and the attached drawings.

The summary of the representative invention, among the embodiments of the invention described in the present application, will be explained below.

A salt of vanadic acid is crystal-grown in a nano-crystallizing process including a process of heat-treating the salt of vanadic acid at a temperature equal to or lower than a predetermined temperature, whereby microcrystals having a layer length of 100 nm or less but not including 0 are produced.

The effect obtained by the representative invention, among the embodiments described in the present application, will briefly be described below.

Different from the conventional method, microcrystals of a vanadium pentoxide having a layer length of 100 nm or less but not including 0 can directly be produced without using a vanadium pentoxide having a crystal structure greater than a nano-vanadium as a material. Therefore, a vanadium pentoxide, present as microcrystal particles that is a nano-vanadium, can be provided at low cost for a field of an electric storage device used for an electrode material or the like.

The present invention is a technique of producing microcrystals of a vanadium pentoxide through a salt of vanadic acid or an ammonium metavanadate. Therefore, the technique can be linked to the conventional production method in which the salt of vanadic acid or the ammonium metavanadate is generated in the course of the method. Accordingly, some existing facilities can be employed, so that the conventional method can quickly be changed to the production method according to the present invention.

### BRIEF DESCRIPTION OF THE DRAWINGS

- FIGS. 1A, 1B, and 1C: are flowcharts illustrating a production method according to the present invention;
- FIG. 2: is a flowchart illustrating a production method according to the present invention;
- FIG. 3A: is an explanatory view schematically illustrating a crystal structure of a nano-vanadium produced by the production method according to the present invention;
- FIG. 3B: is a schematic view illustrating a layer length of nano-vanadium;
- FIG. 4: is a flowchart illustrating one example of a conventional production method;
- FIG. 5: is an explanatory view schematically illustrating one example of an electric storage device; and
- FIGS. 6A and 6B: are explanatory views illustrating the relationship between a heat treatment and a rate of capacity deterioration.

### DETAILED DESCRIPTION OF THE PREFERRED EMBODIMENTS

An embodiment of the present invention will be explained in detail below with reference to the figures. In all the figures for explaining the embodiment, the same components are identified by the same numerals, and the description will not be repeated.

The present invention is a technique relating to an electrode material. The present invention relates to a layered crystal material usable for an electrode. Specifically, the layered crystal material has microcrystal particles of a vanadium oxide having a layer length of more than 0 nm and 100 nm or less. As described above, the microcrystals of the vanadium oxide, such as a vanadium pentoxide, having a layer length of 100 nm or less may sometimes briefly be referred to as a nano-vanadium below.

Examples of the microcrystal particles described above include microcrystal particles of a vanadium pentoxide, which is a nano-vanadium. This material can effectively be used as a positive electrode active material of an electric storage device. This material can also effectively be used as an active material that allows lithium ions to be easily doped or de-doped between the layers of the microcrystal structure. The material can effectively be used in a lithium ion secondary battery or the like.

The term "layer length" in the specification of the present application means a length of a layer in a layered crystal structure. For example, it may be represented by an average diameter of primary particles determined by the observation with an electron microscope or X-ray diffraction analysis.

In the specification of the present invention, the term "doping (dope)" involves "occlude", "carry", "adsorb" or "insert", and specifically a phenomenon where lithium ions or anions enter the positive electrode active material or the negative electrode active material. The term "de-doping (de-dope)" involves "release" and "desorb", and specifically a phenomenon where lithium ions or anions desorb from the positive electrode active material or the negative electrode active material.

The present invention is characterized by being capable of being combined to a conventional production method. Specifically, the present invention is a production technique that can utilize some of the conventional production methods partly. The present invention can promptly be embodied by employing the configuration described above.

A single and high-quality vanadium ore has not been known. The vanadium is a by-product of a vanadium-containing titanic magnetite during the collection of other metals. Further, the production thereof is unevenly distributed to some regions on earth. The vanadium is contained more in crude oil, and a combustion ash can be utilized as a material. The demand for vanadium in Japan is completely covered by import. In the import, the vanadium is traded as a ferrovanadium or vanadium pentoxide.

The present inventors have paid attention to the vanadium pentoxide, and studied the conventional production method. The present inventors have paid attention to a method of producing a vanadium pentoxide with the combustion ash being used as a material. The production method includes a plurality of processes. The present inventors have found that a specific vanadium compound becomes a key in the method. If the microcrystal particles of the vanadium pentoxide can be produced with the specific vanadium compound being used as a material, the method can be linked to the conventional production method.

The specific vanadium compound is a salt of vanadic acid and an ammonium metavanadate (same as an ammonium vanadate). In the conventional production method, the vanadium is extracted as a salt of vanadic acid from an aqueous solution of a roasted combustion ash. A solid of the ammonium metavanadate is taken from the extracted salt of vanadic acid with a salting-out. Thereafter, the ammonium metavanadate is heated to 600 °C or more so as to desorb the ammonium, whereby the vanadium pentoxide is produced.

The present inventors have paid attention to the ammonium metavanadate that is formed in the last process in the production method. Specifically, the present inventors have studied whether the microcrystals of the vanadium pentoxide, which is the nano-vanadium, can be produced from the ammonium metavanadate. As a result of the keen examination, the present inventors have found that the microcrystal particles can be produced by controlling the temperature.

The present invention is **characterized in that** the ammonium metavanadate is heated to a predetermined temperature so as to form the microcrystals of the vanadium pentoxide. Specifically, the present inventors have found out for the first time that the microcrystal structure of a nano-vanadium can be produced by heating the ammonium metavanadate to a predetermined temperature, and so the present inventors have conceived the present application.

The ammonium metavanadate is heated to 100 °C or more, more preferably to 150 °C or more, so that the microcrystals of the vanadium pentoxide, which is a nano-vanadium, can be produced. The temperature is preferably 150 °C or more, since the complete microcrystals can be formed with this temperature. The upper limit of the heating temperature is 500 °C in the current study. Specifically, the ammonium metavanadate is heated to 100 °C or more and 500 °C or less, whereby the microcrystal particles of the vanadium pentoxide can be formed. Alternatively, it has been found for the first time that the ammonium metavanadate is heated to 150 °C or more and 500 °C or less, whereby the microcrystal particles of the vanadium pentoxide can be formed.

During the heat treatment at the temperature described above, the microcrystals of the vanadium pentoxide can be formed with the rate of temperature rise of 0.5 °C/min or more and 30 °C/min or less. This condition has been confirmed by the experiment this time. If the rate of temperature rise is less than 0.5 °C/min, much time is taken, so that this is impractical. On the other hand, when the rate of temperature rise exceeds 30 °C/min, the rate of temperature rise is too fast, so that the crystal is likely to be coarse.

Within the range of 0.5 °C/min or more and 30 °C/min or less, the range of 1 °C/min or more and 10 °C/min or less is preferable. From the viewpoint of practicability in production efficiency, the range of 3 °C/min or more is preferable. When the rate of temperature rise is 30 °C/min or less, the layer length of the crystal structure included in the microcrystals is preferably suppressed 100 % or near 100 % to be 100 nm or less.

After the temperature has reached the target temperature with the rate of temperature rise described above, the temperature is desirably maintained. This is because crystals having a layer length not satisfying the predetermined size might exist. However, when the rate of temperature rise is low, the temperature does not have to be maintained at the target temperature. Instead, the temperature is not maintained at the target temperature in order to avoid the generation of the growth of the crystals having a layer length larger than the predetermined size. Whether the temperature is maintained at the target temperature or not can appropriately be determined by the process in which the obtained crystals are sampled and the crystal state thereof is grasped.

After the microcrystal particles of the vanadium pentoxide have been produced as described above, the temperature can be gently lowered. For example, the temperature can naturally be lowered to a room temperature. The rapid temperature drop might affect the crystal structure, although a detailed study has not yet been made.

The layer length of the microcrystals can be adjusted by changing the temperature condition as described above. Thus, a nano-vanadium having the optimum layer length can be produced.

The nano-vanadium was produced under an oxygen partial pressure of within 0 % or more and 100 % or less in the experiment. Further, the employed atmosphere of the heat treatment is a rare gas atmosphere such as an oxygen atmosphere, argon (Ar) atmosphere, helium (He) atmosphere, or the like.

Microcrystals of a vanadium pentoxide having a layer length of 100 nm or less can directly be produced by the method in which the ammonium metavanadate is used as a starting material, and it is heat-treated at 150 °C or more and 500 °C or less as described above.

The ammonium metavanadate according to the present invention is generated in the course of the conventional known production method as described above. Since the vanadium is contained more in a crude oil, in particular, a combustion ash is used as a material for the production of the vanadium. The combustion ash is roasted, and an alkali metal salt of vanandium acid is temporarily extracted from the aqueous solution. Further, a soluble alkali metal salt of vanadium acid is salted out to form the ammonium vanadate.

For example, the combustion residue in a boiler is roasted, and then a sodium vanadate is temporarily extracted from the sodium aqueous solution. The aqueous solution of the soluble sodium vanadate is salted out by an ammonium compound, whereby the ammonium vanadate is formed.

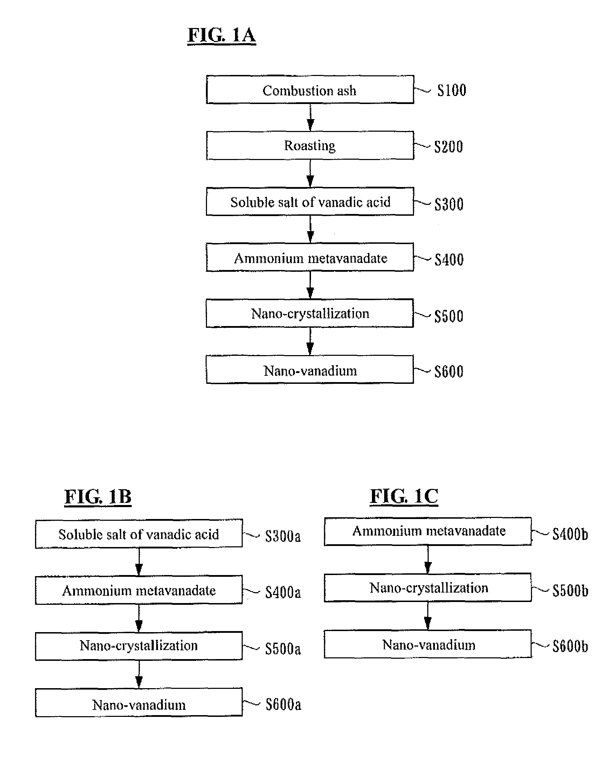

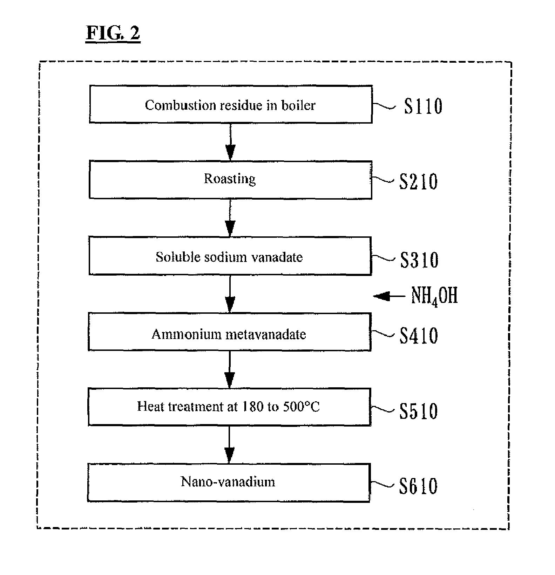

FIGS. 1A, 1B, 1C, and 2 illustrate the flowchart of the production method of the nano-vanadium according to the present invention. Specifically, a combustion ash is prepared at step S100 in FIG. 1A. For example, combustion residue in a boiler can be prepared as shown in step S110 in FIG. 2. Thereafter, the combustion ash prepared is roasted at step S200. For example, the combustion residue in the boiler is roasted at 700 °C to 850 °C at step S210.

At step S300 in FIG. 1A, a vanadium is extracted from the aqueous solution of the roasted ash as a soluble salt of vanadic acid such as an alkali metal salt of vanadic acid. For example, the vanadium is extracted as a soluble sodium vanadate as shown in step S310 in FIG. 2.

In the present invention, the soluble salt of vanadic acid formed at step S300a can be used as a starting material as illustrated in FIG. 1B.

Examples of the salt of vanadic acid include those formed by ionically-bonding VO₄³⁻, V₂O₇⁴⁻, V₁₀O₂₈⁶⁻, V₄O₁₂⁴⁻, V₃O₉³⁻, HVO₄²⁻, H₂VO₄⁻, HV₁₀O₂₈⁵⁻, and H₂V₁₀O₂₈⁴⁻ with cation. Examples of the cations include sodium, ammonium, potassium, cesium, rubidium, silver, alkyl ammonium, etc. Specific examples of the salt of vanadic acid include a sodium metavanadate (same as a sodium vanadate) or the like in addition to the ammonium metavanadate described in the present embodiment. In other words, a sodium metavanadate or other salts of vanadic acid is applicable in addition to the ammonium metavanadate used in the examples described below.

Then, the ammonium metavanadate is salted out from the soluble alkali metal salt of vanadic acid, for example, at steps S400 and step S400a as shown in FIGS. 1A and 1B. For example, an ammonium hydroxide is added to the aqueous solution of the sodium vanadate so as to salt out the ammonium metavanadate as shown in step S410 in FIG. 2.

In the present invention, the ammonium metavanadate formed at step S400b can be used as a starting material as illustrated in FIG. 1C.

Thereafter, a nano-crystallizing process is performed as shown at steps S500, S500a, and S500b in FIGS. 1A, 1B, and 1C. As shown at step S510 in FIG. 2, the material can be heated to, for example, 150 °C or more and 500 °C or less.

A nano-vanadium is formed as shown at steps S600, S600a, S600b, and S610 in FIGS. 1A, 1B, 1C, and 2. Specifically, a nano-vanadium, which is present as microcrystals of the vanadium pentoxide, having a layer length of 100 nm or less but not including 0 can be formed.

In the heat treatment, the starting material is heated with a rate of temperature rise of 0.5 °C/min or more and 30 °C/min or less. When the rate of temperature rise is less than 0.5 °C/min, which is extremely slow from the viewpoint of the practical production, it takes much time. When the rate of temperature rise exceeds 30 °C/min, the rate of temperature rise is too fast, which allows the crystals to be coarse. More preferably, the rate of temperature rise is 1 °C/min or more and 10 °C/min or less. The temperature basically increases slowly. It is preferable that the temperature rises slowly during the time for the process at the real production site.

It can be programmed such that the rate of temperature rise increases up to the temperature range lower than the target temperature, and the rate of temperature rise lowers in the vicinity of the target temperature. By doing so, the object can be achieved, even if the time taken for the total process is cut.

In the heat treatment, when the temperature reaches the target temperature of 100 °C or more and 500 °C or less, the time for maintaining the temperature can be set depending on the crystal state as described above. Of course, the time for maintaining the temperature can be set to zero as described above.

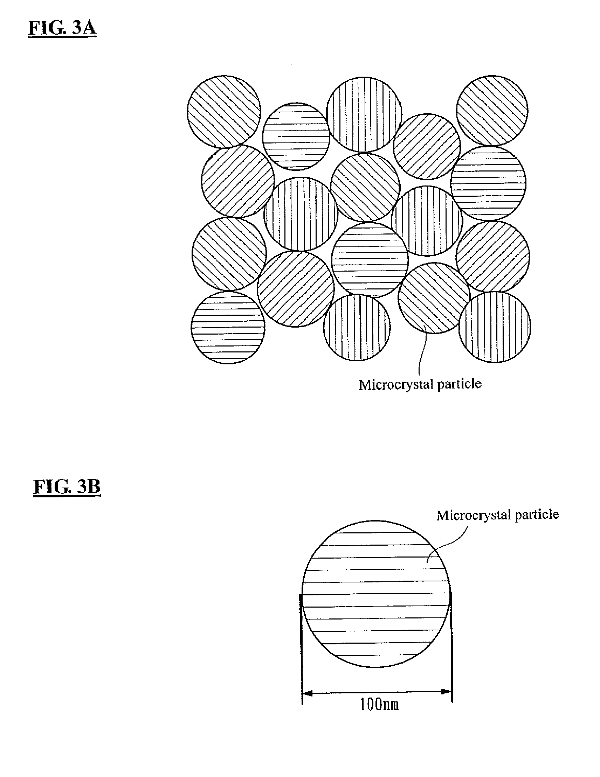

The state of the layered crystal particles of the nano-vanadium formed at steps S600, S600a, S600b, and S610 is schematically illustrated in FIG. 3A. FIG. 3A illustrates the state of the three-dimensional microcrystals as viewed from one section. The layered microcrystal particles of the vanadium pentoxide, which is the nano-vanadium, is indicated by a circle. The layered state is illustrated as parallel lines in the circle. As shown in FIG. 3B, a microcrystal particle of the vanadium pentoxide, which is the nano-vanadium, has a layer length of 100 nm or less but not including 0,

The state of the presence of the nano-vanadium can be verified from a sectional photograph with the use of an SEM. The present inventors have currently considered that there is no problem in a cycle performance, if the average presence ratio of the layered crystal particles having a layer length of 100 nm or less is at least 95 % or more, for example.

As schematically illustrated in FIG. 3A, a space is formed between the layered crystal particles, and by that much, an electrolyte solution is easy to be permeated. Therefore, when the layered crystal particles are used as an active material of an electrode, the contact efficiency between the layered microcrystal particles and the electrolyte solution enhances, with the result that a high cycle performance is obtained.

An electrode of an electric storage device such as a battery can be produced by using the nano-vanadium formed at steps S600, S600a, S600b, and S610. According to the production method of the present invention illustrated in FIGS. 1A, 1B, 1C, and 2, a nano-vanadium can be formed without using a large layered crystal material of a vanadium pentoxide having a layer length of 100 nm or more. A nano-vanadium, which is a layered crystal material of the vanadium pentoxide having a layer length of 100 nm or less, can be formed. The layered crystal material of the nano-vanadium can effectively be used as an electrode material of an electric storage device such as a battery.

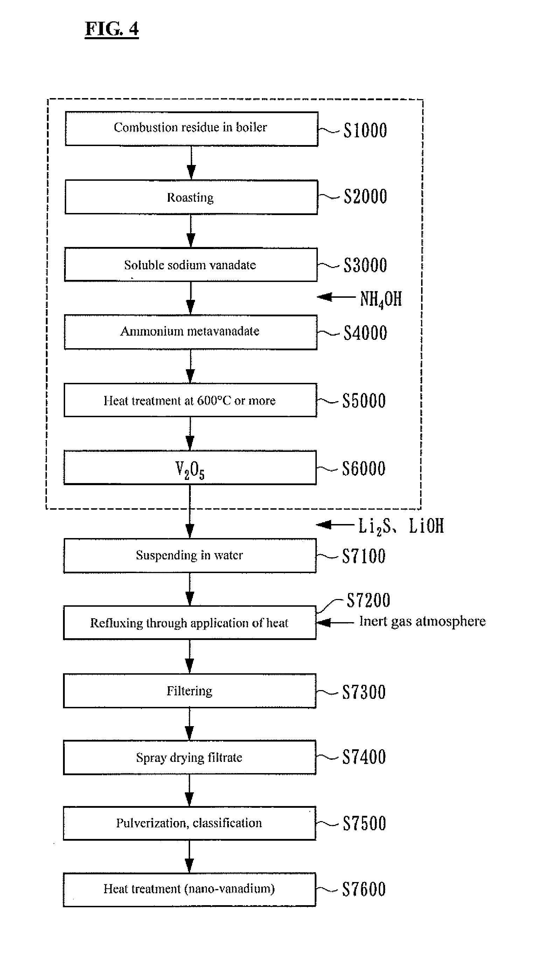

Conventionally, a nano-vanadium is formed, for example, along the flowchart shown in FIG. 4, different from the present invention. Specifically, a combustion ash such as a combustion residue in a boiler is prepared at step S1000. The prepared combustion ash is roasted at step S2000. The vanadium is extracted as an alkali metal salt of vanadic acid such as a soluble sodium vanadate at step S3000.

The resultant is salted out with the use of an ammonium hydroxide at step S4000 so as to form an ammonium metavanadate. The formed ammonium metavanadate is heated to, for example, 600 °C or more to perform a heat treatment. Large crystals of a vanadium pentoxide having a layer length of at least more than 100 nm is formed at step S6000.

Then, the nano-vanadium, which is obtained as microcrystals of a vanadium pentoxide, is produced by using, as a material, the large crystal of the vanadium pentoxide having a layer length of more than 100 nm formed at step S6000.

Specifically, at step S7100, the vanadium pentoxide formed at step S6000 and a plurality of lithium materials such as lithium sulfide and lithium hydroxide are suspended in water. The resultant is refluxed through an application of heat under an inert gas atmosphere at step S7200. The suspended solution, which has been refluxed through the application of heat, is filtered at step S7300. The filtrate is dried by spray drying at step S7500. The dried filtrate is pulverized and classified at step S7500. At step S7600, the resultant formed at step S7500 is subject to heat treatment to make the vanadium pentoxide a nano-vanadium.

As described above, the vanadium pentoxide having a layer length of more than 100 nm is temporarily produced in the conventional production method. Further, the vanadium pentoxide is re-crystallized through the process of dissolving the vanadium pentoxide into water so as to obtain microcrystal particles of the vanadium pentoxide, which is a nano-vanadium, having a layer length of 100 nm or less.

However, as illustrated in FIGS. 1A, 1B, 1C, and 2, the number of processes can remarkably be decreased in the production method according to the present invention, compared to the conventional method shown in FIG. 4. For example, the steps S 1000 to S6000 encircled by a broken line in FIG. 4 are changed to the steps S110 to S610 encircled by a broken line in FIG. 2, whereby the steps S7100 to 7600 are totally eliminated in the present invention.

The nano-vanadium formed according to the production method of the present invention can be used as an electrode material of an electric storage device. Specifically, it can be used, for example, as an active material of a positive electrode in a lithium ion secondary battery of an electric storage device.

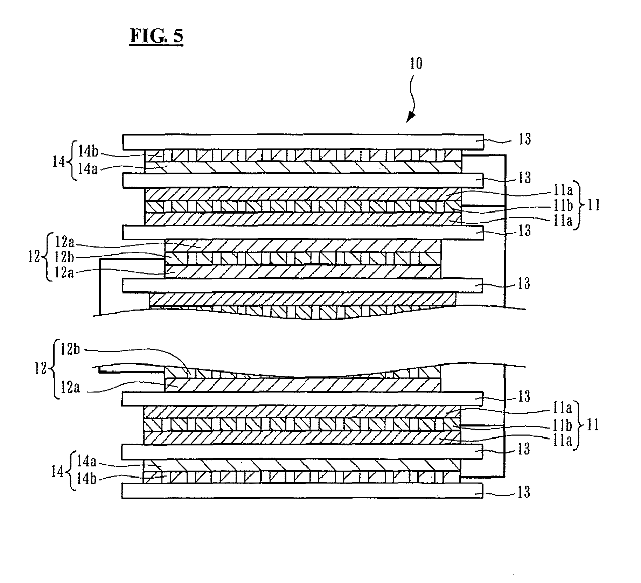

The lithium ion secondary battery 10 as an electric storage device has the structure shown in FIG. 5, for example. The lithium ion secondary battery 10 has negative electrodes 11 and positive electrodes 12 that are laminated in an alternating fashion. A separator 13 is provided between each of the negative electrodes 11 and each of the positive electrodes 12.

The negative electrodes 11 are provided at the outermost parts of a laminate unit having a plurality of negative electrodes 11 and the positive electrodes 12. Specifically, the structure in which the positive electrodes 12 and the negative electrodes 11 are laminated in an alternating fashion with the separators 13 provided therebetween is sandwiched between both negative electrodes 11. Thus, an electrode unit is formed.

Lithium electrodes 14 are provided at the outside of the outermost layers of the negative electrodes 11 arranged at the outermost parts. The lithium electrodes 14 are provided so as to be opposite to the negative electrodes 11 arranged at the outermost parts. Each of the lithium electrodes 14 has, for example, a current collector 14b and a metal lithium 14a mounted on the current collector 14b with a predetermined thickness. The current collector 14b is a porous member having holes formed therein. Lithium ions eluted from the lithium electrode 14 is pre-doped into the negative electrode 11.

Each of the negative electrodes 11 constituting the electrode unit has a current collector 11b and a negative electrode active material 11a provided on the current collector 11b with a predetermined thickness. The current collector 11b is a porous member having holes formed therein. Each of the positive electrodes 12 has a current collector 12b and a positive electrode active material 12a provided on the current collector 12b with a predetermined thickness. The current collector 12b is a porous member having holes formed therein.

The electrode unit having the aforesaid structure is impregnated into electrolyte solution, whereby the lithium ion secondary battery 10 is constituted.

The negative electrode active material and the positive electrode active material are respectively mixed with binder, conductive assistants, and water so as to be formed into slurry. The active material formed into the slurry is applied onto the corresponding current collector with a predetermined thickness by a die coater or the like. Then, the slurry is dried, whereby both electrodes serving as the negative electrode 11 and the positive electrode 12 are formed.

The materials described below can be used for the negative electrode active material. Examples of the materials include a lithium-intercalated carbon material, etc., in the case of a non-aqueous lithium ion secondary battery. Examples of the carbon materials include graphite, carbon-based material, polyacene-based material, etc. Examples of the carbon-based material include non-graphitizable carbon material, etc. Examples of the polyacene-based material include PAS that is an insoluble and infusible base and has a polyacene skeletal structure. The negative electrode active materials allow lithium ions to be reversibly doped.

When the carbon material or the like that allows lithium ions to be doped or de-doped is used, the lithium electrode is separately provided in order to pre-dope the lithium ions from the lithium electrode to the negative electrode at the initial charging. Examples of the lithium ion source include metal lithium or lithium-aluminum alloy. Specifically, the material that contains at least lithium elements and can supply lithium ions can be used.

The layered crystal material of vanadium pentoxide, which is a nano-vanadium, manufactured by the manufacturing method according to the present invention is used as the positive electrode active material. For example, it is used as the positive electrode active material of the non-aqueous lithium secondary battery shown in FIG. 5. It is preferable that the lithium ions are doped in a ratio of 0.1 to 6 in a molar ratio with respect to the metal oxide of vanadium pentoxide. When the doping amount of the lithium ions is less than 0.1 in a molar ratio, the doping effect cannot sufficiently be exhibited. On the other hand, when the doping amount of the lithium ions exceeds 6, the metal oxide might be reduced to metal unpreferably.

Polyvinylidene fluoride (PVDF) or the like can be used as a binder. The binder described above is preferably mixed with the conductive particles described later to form slurry. The slurry is applied onto the conductive base, which is the current collector described below, with a predetermined thickness, whereby the electrode is formed.

Examples of the conductive assistant include the following conductive particle, that is, conductive carbon such as Ketchen black, metal such as copper, iron, silver, nickel, palladium, gold, platinum, indium, tungsten, conductive metal oxide such as indium oxide, tin oxide, etc. The conductive particle can be contained in a ratio of 1 to 30 % per weight of the metal oxide.

Lithium alloy can also be used as the lithium electrode instead of the metal lithium. Examples of the lithium alloy include lithium-based metal material such as Li-Al alloy. Other examples of the lithium alloy include intermetallic compound material of a metal such as tin or silicon and a lithium metal, lithium compound such as lithium nitride, or the like.

The conductive base that exhibits conductivity at the surface in contact with the positive electrode active material and the negative electrode active material is used for the perforated current collector, for example. Examples of the base include a conductive material such as metal, conductive metal oxide, conductive carbon, etc. In particular, the base can be formed of copper, gold, aluminum, or alloy of these metals, or conductive carbon. When the base is made of a non-conductive material, the base is coated with a conductive material for use.

The non-aqueous solvents described below can be used for the electrolyte solution into which the laminate unit having the aforesaid structure is impregnated. Examples of the non-aqueous solvent include chain carbonate, cyclic carbonate, cyclic ester, nitrile compound, acid anhydride, amide compound, phosphate compound, amine compound, etc.

More specifically, examples thereof include ethylene carbonate, diethyl carbonate (DEC), propylene carbonate, dimethoxyethane, γ-butyloractone, n-methyl pyrrolidinone, N,N'-dimethyl acetoamide, acetonitrile, mixture of propylene carbonate and dimethoxyethane, mixture of sulfolane and tetrahydrofuran, etc.

Examples of the electrolyte dissolved into the electrolyte solution include lithium salt such as CF₃SO₃Li, C₄F₉SO₈Li, (CF₃SO₂)₂NLi, (CF₃SO₂)₃CLi, LiBF₄, LiPF₆, LiClO₄, etc. The solvent into which the electrolyte is dissolved is non-aqueous solvent. The electrolyte layer interposed between the positive electrode and the negative electrode can be a polymer gel (polymer gel electrolyte) containing non-aqueous solution of the electrolyte. Since vanadium pentoxide of layered crystal material is dissolved into the water, the use of the non-aqueous solvent is demanded as described above.

### EXAMPLES

### Fabrication of positive electrode

In the present example, an ammonium metavanadate is used as a material, and this material is nano-crystallized so as to form a microcrystal of a vanadium pentoxide. For example, 10 g of ammonium metavanadate (manufactured by Kanto Chemical Co., Inc.) was heated to a target temperature with a rate of temperature rise of 5 °C/min with the use of an electric furnace that was controlled by a program controller with a PID-control function. In the experiment, the target temperature was set to 150 °C (Example 1), 180 °C (Example 2), 200 °C (Example 3), 400 °C (Example 4), and 500 °C (Example 5), respectively, to form microcrystals of a vanadium pentoxide, which was a nano-vanadium.

The target temperature was maintained for 0.6 hours. Thereafter, the crystal was left to lower the temperature to room temperature. The experiment was carried out under an oxygen partial pressure of 20 % and under oxygen atmosphere. As a result, microcrystal particles of a vanadium pentoxide having a layer length of 100 nm or less were formed in the respective Examples.

90 wt. % of the layered crystal material, which was the microcrystal particles of vanadium pentoxide in Examples 1 to 5, was mixed with 5 wt. % of conductive carbon black and 5 wt. % of polyvinylidene fluoride (PVDF), and N-methyl pyrrolidone (NMP) was used as solvent to form slurry. The thus obtained slurry was applied onto a porous aluminum foil by a doctor blade method in such a manner that the mixture density per one surface became 2 g/cm³. The slurry was applied on both surfaces or one surface of a copper current collector having through-holes, and the resultant was molded. The molded one was cut in a size of 24 mm x 36 mm to obtain positive electrodes.

### Fabrication of negative electrode

Graphite and PVDF serving as a binder were mixed in a weight ratio of 94 : 6 so as to prepare slurry that was diluted with NMP. The thus formed slurry was applied onto both surfaces or one surface of a copper current collector having through-holes in such a manner that the mixture density per surface became 1.7 mg/cm³. The resultant was molded, and cut in a size of 26 mm x 38 mm to obtain negative electrodes.

### Fabrication of battery

Twelve positive electrodes and thirteen negative electrodes (two of them had one applied surface) thus obtained were laminated through a polyolefin-based microporous film serving as a separator. A lithium electrode, which had metal lithium adhered onto a stainless porous foil through a separator, was arranged at the outermost layer, whereby a three-electrode laminate unit composed of the positive electrodes, negative electrodes, lithium electrodes, and separators were fabricated. The three-electrode laminate unit was packaged with an aluminum laminate film, and electrolyte solution in which lithium borofluoride was dissolved in 1 mol/l with a weight ratio of ethylene carbonate (EC)/diethyl carbonate (DEC) = 1/3 was injected therein.

### Measurement of rate of capacity deterioration

The batteries according to the Examples 1 to 5 fabricated as described above were left for 20 days. Then, when one cell of them was disassembled, no metal lithium remained. It was confirmed from this result that the lithium ions in a required amount were carried and doped, i.e., pre-doped, beforehand into the negative electrodes.

The battery of remaining one cell was subject to the charging/discharging cycle test. The battery was charged in a constant current-constant voltage (CC-CV) charging method. Specifically, the battery was charged with 0.1 C and 4.1 V. After 30 hours have elapsed, the test was ended. The battery was discharged with a constant current (CC) discharging method in which the test was ended when the current assumed 0.05 C and the voltage assumed 1.35 V. The rate of capacity deterioration was calculated in terms of percentage with respect to the discharge capacity immediately before the discharge capacity.

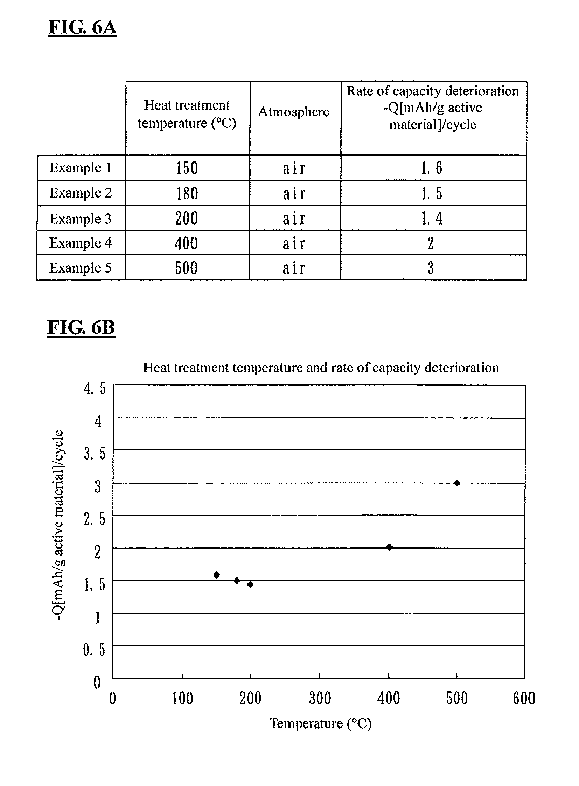

FIGS. 6A and 6B show the result of the measurement. As shown in FIGS. 6A and 6B, the rate of capacity deterioration represented by -Q (mAh/g active material)/cycle at 150°C was 1.6. Similarly, the rates of capacity deterioration when each of the microcrystals of the vanadium pentoxide formed at 180°C, 200 °C, 400 °C, and 500 °C was used was 1.5, and 1.4, and 2, and 3, respectively. The rate of capacity deterioration could be suppressed to be low.

The present invention has been specifically described above with reference to the embodiments and examples. However, the present invention is not limited to the aforesaid embodiments and examples, and various modifications are possible without departing from the scope of the present invention.

The present invention is well adaptable to a field of a positive electrode used in a lithium ion secondary battery.

### LIST OF REFERENCE SIGNS

- 10: lithium ion secondary battery
- 11: negative electrodes
- 11a: negative electrode active material
- 11b: current collector
- 12: positive electrodes
- 12a: positive electrode active material
- 12b: current collector
- 13: separator
- 14: Lithium electrodes
- 14a: metal lithium
- 14b: current collector

## Claims

1. A production method of a layered crystal material of microcrystals of a vanadium oxide having a layer length of 100 nm, the method comprising:
- a nano-crystallizing process for growing crystals so as to have a layer length of 100 nm or less, wherein
the nano-crystallizing process includes a heat-treatment process for heating a salt of vanadic acid at a temperature equal to or less than a predetermined temperature.

2. The method according to claim 1,
wherein the nano-crystallizing process includes a process for heat-treating an ammonium metavanadate to 500°C or less.

3. The method according to claim 1 or 2,
wherein the ammonium metavanadate is heat-treated to 150°C or more.

4. The method according to claim 2 or 3,
wherein the ammonium metavanadate is formed by salting-out from a soluble salt of vanadic acid.

5. The method according to claim 4,
wherein the soluble salt of vanadic acid is a salt of an alkali metal.

6. The method according to claim 4 or 5,
wherein the soluble salt of vanadic acid is a sodium salt.

7. The method according to any one of claims 4 to 6,
wherein the soluble salt of vanadic acid is formed with a combustion ash being used as a material.

8. The method according to any of claims 1 to 7,
wherein the microcrystals having a layer length of 100 nm or less but not including 0 are used for an electrode (11, 12) of an electric storage device (10).

9. The method according to claim 8,
wherein the electric storage device (10) is a lithium ion secondary battery.
